**Europäisches Patentamt**

**European Patent Office**

**Office européen des brevets**

(19)

(11) Publication number: **0 116 117**
**B1**

(12) **EUROPEAN PATENT SPECIFICATION**

(45) Date of publication of patent specification: **14.06.89**

(21) Application number: **83110286.8**

(22) Date of filing: **15.10.83**

(51) Int. Cl.⁴: **H 01 L 21/60, H 01 L 21/58,**
**H 01 L 23/48, G 01 N 27/00**

(54) **A method of establishing electrical connections at a semiconductor device.**

(30) Priority: **21.10.82 US 435845**

(43) Date of publication of application:
**22.08.84 Bulletin 84/34**

(45) Publication of the grant of the patent:
**14.06.89 Bulletin 89/24**

(84) Designated Contracting States:
**BE DE FR GB IT**

(56) References cited:
**GB-A-2 079 534**
**US-A-3 691 628**
**US-A-4 322 680**
**US-A-4 393 130**
**US-A-4 449 011**

**IBM TECHNICAL DISCLOSURE BULLETIN, vol.
13, no. 2, July 1970, page 474, New York, US;
F.HAIST et al.: "Packaging"**

**PATENTS ABSTRACTS OF JAPAN, vol. 6, no.
211(E-137)(1089), 23rd October 1982 & JP - A -
57 115 850**

(73) Proprietor: **ABBOTT LABORATORIES**
**14th Street and Sheridan Road North St**
**North Chicago Illinois 60064 (US)**

(72) Inventor: **Bose, Ashesh Eric**
**1431 West Elmdale Avenue**
**Chicago Illinois (US)**

(74) Representative: **Modiano, Guido et al**
**MODIANO, JOSIF, PISANTY & STAUB Modiano
& Associati Via Meravigli, 16
I-20123 Milan (IT)**

(56) References cited:
**ELECTRONICS, vol. 43, no. 7, 30th March 1970,
pages 126-131, New York, US; "LSI makers pick
up the pieces"**

**PATENTS ABSTRACTS OF JAPAN, vol. 6, no.
32(E-96)(910), 26th February 1982 & JP - A - 56
153 755**

**ELECTRONICS, vol. 40, no. 15, 24th July 1967,
page 37, New York, US; "Facing up to the chip"**
**PATENTS ABSTRACTS OF JAPAN, vol. 6, no.
67(E-104)(945), 28th April 1982 & JP - A - 57
7147**

EP 0 116 117 B1

(56) References cited:
**PATENTS ABSTRACTS OF JAPAN, vol. 7, no.
88(E-170)(1233), 12th April 1983 & JP - A - 58
14545**

## Description

Background of the invention

Reference may be made to the following United States patents of interest: 3,831,432; 4,020,830; 4,198,851; 4,218,298; and 4,269,682.

As can be seen by reference to the above-listed United States patents, as well as to various publications cited in these patents, it has been proposed to utilize semiconductor sensors, specifically field effect transistors (FET) containing separate source and drain electrodes with a gate region therebetween, to detect and/or measure gases, enzymes, ion activity, and a variety of substances in for instance chemical, biochemical and electrochemical applications. Such proposed devices have been known as chemical sensitive field effect transistors, and may be referred to hereinafter as CSFET. The CSFET is formed on a semiconductor chip containing a field effect transistor.

Such CSFET devices incorporate a chemical sensitive membrane or film in the gate region exposed to a particular substance to be sensed, detected or measured, with the remainder of the device being encapsulated so as to hermetically seal the device, except for the gate region. A typical FET measures about 0.76 mm (0.030 inch) by 0.76 mm (0.030 inch), with the gate region generally being about 0.38 mm (0.015 inch) by 0.51 mm (0.020 inch) and the FET electrodes being about 0.127 mm (0.005 inch) wide. The conventional method of connecting the FET electrodes on a semiconductor chip to an outer electrical circuit is to bond wire between the FET electrodes and the electrical circuit by a thermal compression bonding technique or ultrasonic means. Since the diameter of the bonding wire varies from about 0.025 mm (0.001 inch) to 0.076 mm (0.003 inch), the wire is extremely brittle and must be protected from mechanical stress and strain, vibrations, thermal expansion and compression. Normally, the bonded wire is protected and reinforced with an adhesive or epoxy material and, of course, must be encapsulated to seal the wires from the particular substance being sensed.

In view of the above-described requirements, and particularly in view of the FET, gate region, and wire size limitations, constructing such CSFET devices have involved expensive, time consuming and very tedious operations, and thus have been restricted to merely making one of a kind laboratory devices.

On the other hand from Electronics, Vol. 43, No. 7, 30 March 1970, pages 126 to 131, New York, US, "LSI makers pick up the pieces" a mounting method is disclosed, comprising mounting chips in two grooves of a half-inch square base, and possibly adhesively attaching them by means of epoxy, laying down an interconnection pattern on the base and inserting the assembly in a larger carrier in turn provided with grooves. Thereafter thick or thin film interconnections are provided between the bases.

It is therefore desired to provide a method of manufacturing a CSFET device in large quantities and with a reliability commensurate with other commercial semiconductor devices.

It is specifically desired to eliminate the requirement for wire bonding of the electrodes on the semiconductor chip to an outer electrical circuit, and yet provide an electrical connection therewith of increased reliability.

These tasks are attained by the method and device, as defined in claims 1 and 13.

Thus, in accordance with the invention, wire bonding is eliminated along with the time consuming and expensive requirement for making the wire bonding. Instead, utilizing the invention allows the FET chip to be readily mounted within the substrate cavity and the required electrical connections to the FET electrodes to be made simultaneously during screen printing of the conductors on the substrate. In addition, according to the preferred embodiment, as defined in claims 2—10, 12 and 14—22 except for the gate region, the remainder of the device is readily and reliably hermetically sealed in a few steps and utilizing only a few components as compared to the timely, costly and painstaking procedure of the prior art which resulted in a much less reliable CSFET device. In practicing this preferred form of the invention, it has been found that of 50 CSFET devices so constructed, 48 devices (96%) operated satisfactory and were of commercial grade quality. In contrast, prior art CSFET devices are typically only useful as laboratory items, and even then do not even approach the construction reliability percentage achieved with the present invention.

In another embodiment of the invention, following mounting of the FET chip in the substrate cavity and screen printing conductors on the substrate and onto the FET electrodes, the sub-assembly can then be subjected to injection molding. The area above the gate region is provided with a spring loaded plunger in the mold to enable the gate region to be left open. While this embodiment of the invention provides the advantages of eliminating undesired wire bonding, the heat developed during the molding process provides less reliability in the resulting CSFET device than the preferred embodiment.

Brief description of the drawings

The invention may be understood by reference to the following description taken in conjunction with the accompanying drawings in which like reference numerals identify like elements in the several figures and in which:

Figure 1 is a perspective view of a CSFET device in one embodiment of the invention in a sandwich configuration;

Figure 2 is an exploded perspective view illustrating the several components of the embodiment shown in Figure 1;

Figure 3 is a sectional perspective view taken generally along the section lines shown in Figure 2, and illustrating screen printed conductors on the substrate overlying and in electrical contact with the FET electrodes;

Figure 4 is a plan view partly cutaway of a CSFET device in the preferred embodiment of the invention in a sandwich configuration; and

Figure 5 is a sectional view taken along the section line 5—5 of Figure 4.

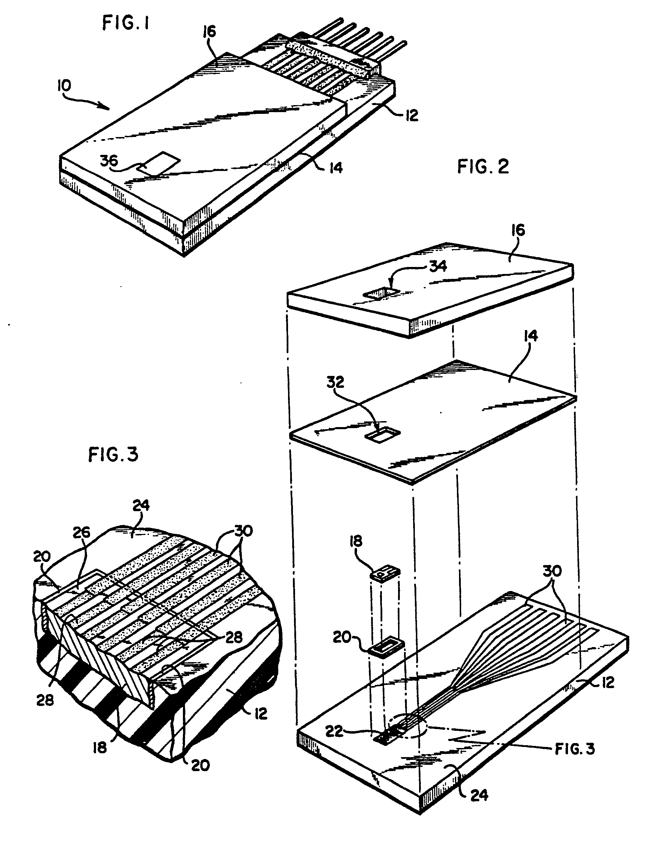

In one embodiment of the invention illustrated in Figures 1—3, a CSFET device 10 is in a sandwich configuration including a base or substrate 12, intermediate thin film 14 of dielectric adhesive material, and a cover 16 which may be bonded to the other components with epoxy, ultrasonic means, or other well-known techniques. A semiconductor chip 18 contains a field effect transistor (FET). An adhesive frame 20 which may be pre-formed of epoxy, is located with in a suitably sized cavity 22 within top surface 24 of base or substrate 12. As can be seen most clearly in Figure 3, FET 18 and adhesive frame 20, when fitted into cavity 22 and with heat applied, results in a bonding of the FET chip within substrate 12 such that FET chip top surface 26 is substantially level or flush with substrate surface 24. Thus, FET electrodes 28 located on surface 26 are substantially flush with substrate surface 24. "Substrate" as used herein refers to the base on which a semiconductor chip is mounted and does not refer to an enzymatic substance.

Conductive elements 30 are screen printed onto substrate surface 24 utilizing well-known techniques. Referring to Figure 3, in accordance with the principles of the present invention, conductors 30 are extended so as to overlyingly contact FET electrodes 28 and thereby provide electrical connection thereto, without requiring wire bonding as in prior devices.

Dielectric film 14 and top cover 16 include respective openings 32 and 34 located so as to be in registered alignment with the gate region on semiconductor FET chip 18. A chemical sensitive membrane 36 is then inserted into openings 34 and 32 and onto the FET gate region. The membrane may be formed of a predetermined chemical sensitive material selected for detecting and/or measuring particular gases, enzymes, ion activity, or other substances in order that the CSFET device may properly sense desired biological or chemical characteristics. Reference may be made to the aforementioned U.S. patents which describe such chemical sensitive membrane materials.

In constructing CSFET 10, base or substrate 12 is formed of a polymer material such as polyvinylchloride, ABS, or similar polymers. Cavity 22 is then formed in the substrate to accommodate a heat activated, self-levelling, pre-formed adhesive, such as epoxy, frame 20 which is placed into and lines the cavity area. The FET chip is then positioned into the epoxy-lined cavity area. Heat is supplied, resulting in curing and bonding of the FET chip flush with the substrate surface. The conductive pads are then screen printed onto the substrate and extended over the FET chip and onto respective FET electrodes so as to make electrical connection therewith.

As is well-known in the art, screen printing can be accomplished with a conductive paste material utilizing air drying adhesives and a silver filled polymer. Heat curable adhesives or ultraviolet light curable adhesives may also be utilized. The conductive paste is applied using standard screen printing techniques. Dielectric adhesive film 14 is then applied over the substrate and FET sub-assembly, excluding the FET gate area, so as to insulate the substrate, screen printed conductor pattern, the FET and the semiconductor chip edges to thereby hermetically seal the unit from the outside environment. Cover 16 is then placed on top of the assembled substrate, FET and adhesive film and bonded thereto with epoxy or other suitable adhesives to improve the handling, and cosmetic appearance of the CSFET unit. Cover 16 can be formed of a polymer material similar to that of substrate 12.

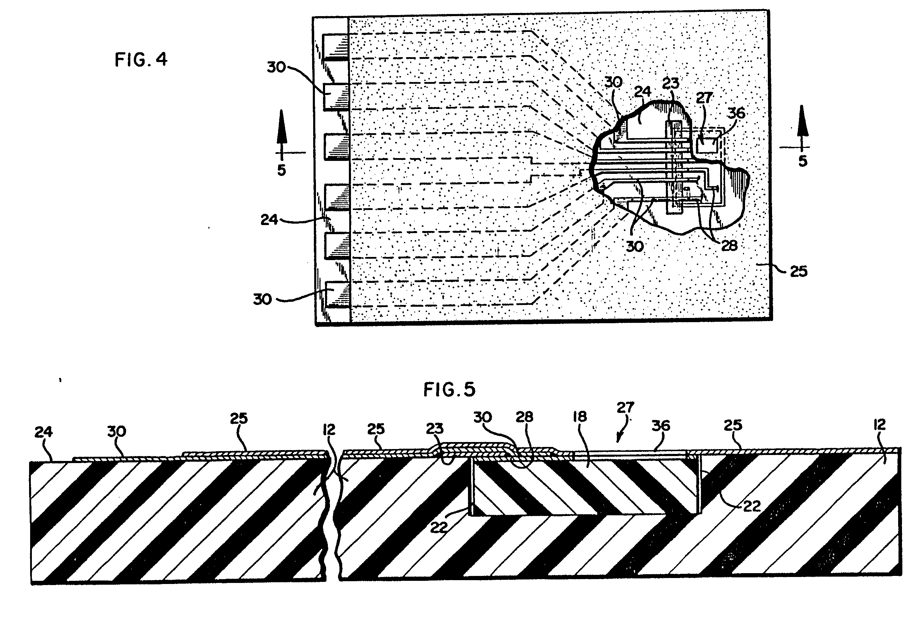

A preferred embodiment of the invention is shown in Figures 4 and 5, wherein semiconductor chip 18 is placed in cavity 22 of base or substrate 12 with an interference fit. Dielectric adhesive pad 23 formed of a polymer material is screen printed on substrate surface 24 and onto a portion of chip 18 to securely maintain the chip in cavity 22. The thin dielectric pad may be 3.175 mm (0.125 inch) long by 0.508 mm (0.020 inch) wide by less than 0.127 mm (0.005 inch) thick. If desired, the walls of cavity 22 may be lined with an epoxy adhesive prior to insertion of chip 18.

Conductors 30 are then screen printed on the substrate surface and extended over dielectric pad 23 so as to make electric contact with respective FET electrodes 28. A thin dielectric adhesive coating 25 of polymer material is applied, such as by screen printing, over the substrate surface to cover conductors 30, FET electrodes 28, and chip 18, excluding FET gate region 27. Coating 25 may be about 0.127 mm (0.005 inch) thick. Chemical sensitive membrane 36 may then be applied at the FET gate region as previously described with respect to Figures 1—3.

As an alternative embodiment, the pre-assembled substrate 12 and FET chip mounted into cavity 22 can be subjected to injection molding to form a CSFET device. While this alternative embodiment also employs screen printing directly onto the FET electrodes to eliminate wire bonding, the additional heat generated during the injection molding process increases the possibility of damaging the CSFET components. Therefore, the embodiments of Figures 4—5 and Figures 1—3 are preferred.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. A method for manufacturing a semiconductor device comprising:
—providing a semiconductor chip (18) with a plurality of contact points (28);
—providing a base (12) having cavity means (22) to hold and position the chip;
—fittingly mounting the chip in the cavity means of the base so as to arrange the contact points of the chip flush with the surface (24) of the base;
—printing a plurality of conductive elements (30) on the base and onto the contact points of the chip to provide electrical connections thereto; and
—hermetically sealing (14, 16; 25) the chip.

2. A method according to claim 1, characterized in that said semiconductor chip is a chemical sensitive field effect transistor (FET) having a gate region (27) and in that the FET and the base are hermetically sealed except for the FET gate region.

3. A method according to claim 1, characterized in that said mounting step includes inserting the chip in said cavity means with the interposition of a mounting frame (20).

4. A method according to any of the preceding claims, characterized in that said mounting step includes the steps of providing a pre-formed epoxy mounting frame, inserting the mounting frame into the cavity means to line it, inserting the chip into the mounting frame, and bonding the semiconductor chip through application of heat.

5. A method according to any of claims 1 and 2, characterized in that the chip is mounted in said cavity means with an interference fit.

6. A method according to any of claims 1, 2 and 5, characterized in that, after said mounting step, a dielectric adhesive pad (23) is printed on the base surface to overlie a portion of the chip for adhesively securing the chip in said cavity means.

7. A method according to any of claims 1, 2, 5 and 6, characterized in that the substrate cavity walls are lined with epoxy before said mounting step and then heat is applied to bond the chip in the cavity means.

8. A method according to claim 1, characterized in that said conductive means are screen printed.

9. A method according to any of the preceding claims, characterized by the step of printing a dielectric adhesive (14, 25) on said base surface, conductive elements and chip except for the FET gate region.

10. A method according to any of the preceding claims, characterized by the step of providing an insulating cover (16) having an opening (34) adapted to the FET gate region and mounting said insulating cover over said base with the opening in alignment with the FET gate region.

11. A method according to any of claims 1—8, characterized by the step of injection molding said chip and base to encapsulate them, except for said FET gate region.

12. A method according to any of the preceding claims, characterized by the step of applying a chemical sensitive material (36) to said FET gate region.

13. A semiconductor device comprising:
a base (12) having cavity means (22) for fittingly accommodating therein a semiconductor chip;
a semiconductor chip (18) having a plurality of contact points (28) arranged flush with the base surface (24);
a plurality of printed conductive elements (30) extending on the base onto the contact points (28) of the chip (18) to provide electrical connection; and means (14, 16; 25) for hermetically sealing the semiconductor chip.

14. A device according to claim 13, characterized in that said chip (18) includes a field effect transistor (FET) having a gate region (27).

15. A device according to claim 13 or 14, characterized by a mounting frame (20) fittingly accommodated in said cavity means and fittingly receiving the semiconductor chip.

16. A device according to any of claims 13 to 15, characterized in that said mounting frame is a preformed adhesive mounting frame.

17. A device according to claim 13 or 14, characterized in that said semiconductor chip (18) is mounted in said cavity means (22) by interference fitting.

18. A device according to any of claims 13, 14 or 17, characterized by a dielectric adhesive pad (23) adapted to adhesively mount said chip (18) in said cavity means (22).

19. A device according to any of claims 13, 14, 17 or 18, characterized in that an epoxy lining is provided between the walls of said cavity means (22) and the chip (18).

20. A device according to any of claims 13 to 19, characterized in that said hermetically sealing means comprises a dielectric film (14, 25) bonded to said base (12), said dielectric film including an opening (32) adapted to register with said FET gate region (27).

21. A device according to any of claims 13 to 20, characterized by an insulating cover (16) bonded to said dielectric film (14), said insulating cover having an opening (34) in registered alignment with said dielectric film opening (32) and said FET gate region (27).

22. A device according to any of claims 13 to 21, characterized by a chemical sensitive material (36) applied to said FET gate region (27).

## Patentansprüche

1. Verfahren zum Herstellen einer Halbleiteranordnung, das aufweist:
—Vorsehen eines Halbleiterchips (18) mit einer Mehrzahl von Kontaktstellen (28),
—Vorsehen eines Trägerteils (12), das einen Hohlraum (22) zum Halten und Positionieren des Chips hat,
—passendes Anbringen des Chips in dem Hohlraum des Trägerteils derart, daß die Kontaktstellen des Chips bündig zur Fläche (24) des Trägerteils sind,

—Aufdrucken einer Mehrzahl von leitenden Elementen (3) auf dem Trägerteil und auf die Kontaktstellen des Chips, um elektrische Verbindungen damit herzustellen, und

—hermetisch dichtes Abschließen (14, 16; 25) des Chips.

2. Verfahren nach Anspruch 1, dadurch gekennzeichnet, daß das Halbleiterchip ein chemisch sensitiver Feldeffekttransistor (FET) ist, der einen Gate-Bereich (27) hat, und daß der FET und das Trägerteil, abgesehen von dem FET-Gate-Bereich, hermetisch dicht abgeschlossen sind.

3. Verfahren nach Anspruch 1, dadurch gekennzeichnet, daß der Anbringungsschritt umfaßt, daß das Chip in den Hohlraum unter Zwischenlage eines Halterahmens (20) eingesetzt wird.

4. Verfahren nach einem der vorangehenden Ansprüche, dadurch gekennzeichnet, daß der Anbringsschritt die Schritte umfaßt, gemäß denen ein vorgeformter Epoxyhalterahmen vorgesehen wird, der Halterahmen in den Hohlraum zur Auskleidung eingesetzt wird, das Chip in den Halterahmen eingesetzt wird und das Halbleiterchip durch Einwirkung von Wärme hiermit verbunden wird.

5. Verfahren nach einem der Ansprüche 1 und 2, dadurch gekennzeichnet, daß das Chip in dem Hohlraum mittels eines Festsitzes angebracht ist.

6. Verfahren nach einem der Ansprüche 1, 2 und 5, dadurch gekennzeichnet, daß nach dem Anbringsschritt ein dielektrisches Klebstoffkissen (23) auf die Trägerteilfläche gedruckt wird, um über einem Teil des Chips zu liegen und das Chip im Hohlraum mittels einer Haftverbindung festzulegen.

7. Verfahren nach einem der Ansprüche 1, 2, 5 und 6, dadurch gekennzeichnet, daß die Substrathohlraumwände vor dem Anbringungsschritt mit Epoxy ausgekleidet sind, und daß dann Wärme zur Einwirkung gebracht wird, um das Chip in dem Hohlraum mittels einer Haftverbindung vorzusehen.

8. Verfahren nach Anspruch 1, dadurch gekennzeichnet, daß die leitenden Einrichtungen mittels Siebdruck vorgesehen werden.

9. Verfahren nach einem der vorangehenden Ansprüche, gekennzeichnet durch den Schritt, gemäß dem ein dielektrischer Klebstoff (14, 25) auf die Trägerteilfläche, die leitenden Elemente und das Chip, abgesehen von dem FET-Gate-Bereich, aufgedruckt wird.

10. Verfahren nach einem der vorangehenden Ansprüche, gekennzeichnet durch den Schritt, gemäß dem eine isolierende Abdeckung (16) vorgesehen wird, die eine Öffnung (34) hat, die an den FET-Gate-Bereich angepaßt ist, und die isolierende Abdeckung über dem Trägerteil angebracht wird, wobei die Öffnung mit dem FET-Gate-Bereich fluchtet.

11. Verfahren nach einem der Ansprüche 1 bis 8, gekennzeichnet durch den Schritt, gemäß dem das Chip und das Trägerteil zur Einkapselung, abgesehen von dem FET-Gate-Bereich, spritzgegossen werden.

12. Verfahren nach einem der vorangehenden Ansprüche, gekennzeichnet durch den Schritt, gemäß dem ein chemisch sensitives Material (36) auf den FET-Gate-Bereich aufgebracht wird.

13. Halbleiteranordnung, die aufweist:

ein Trägerteil (12), das einen Hohlraum (22) zur passenden Aufnahme eines Halbleiterchips darin hat,

einen Halbleiterchip (18), der eine Mehrzahl von Kontaktstellen (28) hat, die bündig zu der Trägerteilfläche (24) liegen,

eine Mehrzahl von gedruckten, leitenden Elementen (30), die auf dem Trägerteil auf den Kontaktstellen (28) des Chips (18) verlaufen, um eine elektrische Verbindung herzustellen, und

eine Einrichtung (14, 16; 25) zum hermetisch dichten Abschließen des Halbleiterchips.

14. Anordnung nach Anspruch 13, dadurch gekennzeichnet, daß das Chip (18) einen Feldeffekttransistor (FET) enthält, der einen Gate-Bereich (27) hat.

15. Anordnung nach Anspruch 13 oder 14, gekennzeichnet durch einen Halterahmen (20), der passend in dem Hohlraum aufgenommen ist und passend das Halbleiterchip aufnimmt.

16. Anordnung nach einem der Ansprüche 13 bis 15, dadurch gekennzeichnet, daß der Halterahmen ein vorgeformter Klebstoffhalterahmen ist.

17. Anordnung nach Anspruch 13 oder 14, dadurch gekennzeichnet, daß das Halbleiterchip (18) im Hohlraum (22) mittels eines Festsitzes angebracht ist.

18. Anordnung nach einem der Ansprüche 13, 14 oder 17, gekennzeichnet durch ein dielektrisches Klebstoffkissen (23), das derart ausgelegt ist, daß das Chip (18) in dem Hohlraum (22) mittels einer Klebstoffverbindung angebracht ist.

19. Anordnung nach einem der Ansprüche 13, 14, 17 oder 18, dadurch gekennzeichnet, daß eine Epoxyauskleidung zwischen den Wänden des Hohlraums (22) und dem Chip (18) vorgesehen ist.

20. Anordnung nach einem der Ansprüche 13 bis 19, dadurch gekennzeichnet, daß die hermetisch dicht schließende Einrichtung einen dielektrischen Film (14, 25) aufweist, der mit dem Trägerteil (12) verbunden ist, wobei der dielektrische Film eine Öffnung (32) enthält, die derart ausgelegt ist, daß sie passend zu dem FET-Gate-Bereich (27) ausgerichtet ist.

21. Anordnung nach einem der Ansprüche 13 bis 20, gekennzeichnet durch eine isolierende Abdeckung (16), die mit dem dielektrischen Film (14) verbunden ist, wobei die isolierende Abdeckung eine Öffnung (34) hat, die zu der dielektrischen Filmöffnung (32) und dem FET-Gate-Bereich (27) ausgerichtet ist.

22. Anordnung nach einem der Ansprüche 13 bis 21, gekennzeichnet durch ein chemisch sensitives Material (36), das auf den FET-Gate-Bereich (27) aufgebracht ist.

**Revendications**

1. Procédé de fabrication d'un dispositif semiconducteur, comprenant les opérations suivantes:

—produire une puce semiconductrice (18) ayant plusieurs points de contact (28);

—produire une base (12) comportant une cavité (22) servant à maintenir et positionner la puce;

—monter de manière ajustée la puce dans la cavité de la base de manière à placer les points de contact de la puce an affleurement avec la surface (24) de la base;

—imprimer plusieurs éléments conducteurs (30) sur la base et jusque sur les points de contact de la puce de manière à établir des connexions électriques avec ceux-ci;

—enfermer hermétiquement (14, 16; 25) la puce.

2. Procédé selon la revendication 1, caractérisé en ce que ladite puce semiconductrice est un transistor à effet de champ (FET) chimiquement sensible qui possède une région de grille (27), et en ce que le FET et la base sont hermétiquement enfermés, à l'exception de la région de grille du FET.

3. Procédé selon la revendication 1, caractérisé en ce que ladite opération de montage comporte l'insertion de la puce dans ladite cavité avec interposition d'un cadre de montage (20).

4. Procédé selon l'une quelconque des revendications précédentes, caractérisé en ce que ladite opération de montage comporte les opérations consistant à produire un cadre de montage en époxy préformée, à insérer le cadre de montage dans la cavité de manière à la chemiser, à insérer la puce dans le cadre de montage, et à souder la puce semiconductrice par application de chaleur.

5. Procédé selon l'une quelconque des revendications 1 et 2, caractérisé en ce qu'on monte la puce dans ladite cavité par ajustement serré.

6. Procédé selon l'une quelconque des revendications 1, 2 et 5, caractérisé en ce que, après ladite opération de montage, on imprime un plot en adhésif diélectrique (23) sur la surface de la base de manière qu'il chevauche une partie de la puce afin de fixer de manière adhésive la puce dans ladite cavité.

7. Procédé selon l'une quelconque des revendications 1, 2, 5 et 6, caractérisé en ce que, avant ladite opération de montage, on chemise les parois de la cavité du substrat à l'aide d'époxy, puis on applique de la chaleur pour souder la puce dans la cavité.

8. Procédé selon la revendication 1, caractérisé en ce qu'on imprime lesdits moyens conducteurs par sérigraphie.

9. Procédé selon l'une quelconque des revendications précédentes, caractérisé par l'opération consistant à imprimer un adhésif diélectrique (14, 25) sur la surface de la base, les éléments conducteurs et la puce, à l'exception de la région de grille du FET.

10. Procédé selon l'une quelconque des revendications précédentes, caractérisé par l'opération consistant à produire un couvercle isolant (16) comportant une ouverture (34) adaptée à la région de grille du FET et à monter ledit couvercle isolant sur ladite base de façon que l'ouverture soit alignée avec la région de grille du FET.

11. Procédé selon l'une quelconque des revendications 1 à 8, caractérisé par l'opération consistant à appliquer un moulage par injection sur la puce et la base afin de les encapsuler, à l'exception de ladite grille du FET.

12. Procédé selon l'une quelconque des revendications précédentes, caractérisé par l'opération consistant à appliquer un matériau chimiquement sensible (36) à ladite région de grille du FET.

13. Dispositif semiconducteur comprenant:

—une base (12) comportant une cavité (22) destinée à loger de manière ajustée une puce semiconductrice;

—une puce semiconductrice (18) ayant plusieurs points de contact (28) placés de manière à affleurer avec la surface (24) de la base;

—plusieurs éléments conducteurs imprimés (30) s'étendant sur la base jusque sur les points de contact (28) de la puce (18) afin de réaliser une connexion électrique; et

—un moyen (14, 16; 25) servant à enfermer hermétiquement la puce semiconductrice.

14. Dispositif selon la revendication 13, caractérisé en ce que ladite puce (18) comprend un transistor à effet de champ (FET) possédant une région de grille (27).

15. Dispositif selon la revendication 13 ou 14, caractérisé par un cadre de montage (20) logé de manière ajustée dans ladite cavité et recevant de manière ajustée la puce semiconductrice.

16. Dispositif selon l'une quelconque des revendications 13 à 15, caractérisé en ce que ledit cadre de montage est un cadre de montage en adhésif préformé.

17. Dispositif selon la revendication 13 ou 14, caractérisé en ce que ladite puce semiconductrice (18) est montée dans ladite cavité (22) par ajustement serré.

18. Dispositif selon l'une quelconque des revendications 13, 14 ou 17, caractérisé par un plot en adhésif diélectrique (23) destiné à monter de manière adhésive ladite puce (18) dans ladite cavité (22).

19. Dispositif selon l'une quelconque des revendications 13, 14, 17 et 18, caractérisé en ce qu'une chemise en époxy est disposée entre les parois de ladite cavité (22) et la puce (18).

20. Dispositif selon l'une quelconque des revendications 13 à 19, caractérisé en ce que ladite moyen d'enfermement hermétique comprend une pellicule diélectrique (14, 25) soudée à ladite base (12), ladite pellicule diélectrique comportant une ouverture (32) conçue pour être en concordance avec ladite région de grille (27) du FET.

21. Dispositif selon l'une quelconque des revendications 13 à 20, caractérisé par un couvercle isolant (16) soudé à ladite pellicule diélectrique (14), ledit couvercle possédant une ouverture (34) disposée en concordance d'alignement avec ladite ouverture (32) de la pellicule diélectrique et ladite région de grille (27) du FET.

22. Dispositif selon l'une quelconque des revendications 13 à 21, caractérisé par un matériau chimiquement sensible (36) appliqué à ladite région de grille (27) du FET.

FIG.1

16

10

36

12

14

FIG. 2

16

34

14

32

FIG.3

24

26

30

20

28

28

18

12

20

18

20

22

24

30

12

FIG. 3

FIG. 4

FIG. 5

EP 0 116 117 B1